# FASCICULE DE BREVET EUROPEEN

(11) **EP 2 815 418 B1**
(45) Date de publication et mention de la délivrance du brevet: **13.06.2018**
(21) Numéro de dépôt: 13708707.8
(22) Date de dépôt: 15.02.2013
(51) Int. Cl.: H01J 37/073, H01J 37/26

(54) **DISPOSITIF ET PROCÉDÉ D'ÉMISSION D'ÉLECTRONS ET SYSTÈME COMPORTANT UN TEL DISPOSITIF**
VORRICHTUNG UND VERFAHREN ZUR EMISSION VON ELEKTRONEN SOWIE ANORDNUNG MIT EINER SOLCHEN VORRICHTUNG
DEVICE AND METHOD FOR EMITTING ELECTRONS AND SYSTEM COMPRISING SUCH A DEVICE

(30) Priorité: 16.02.2012 FR 1251450
(43) Date de publication de la demande: 24.12.2014
(73) Titulaire: Centre National de la Recherche Scientifique (C.N.R.S.), 75794 Paris Cedex 16 (FR)
(72) Inventeur: ARBOUET, Arnaud, F-31520 Ramonville-Saint-Agne (FR); HOUDELLIER, Florent, F-31000 Toulouse (FR)
(74) Mandataire: Priori, Enrico
(86) Numéro de dépôt international: PCT/EP2013/053127
(87) Numéro de publication internationale: WO 2013/121021

(56) Documents cités:
- DE-A1- 19 604 272
- JP-A- H 117 913
- JP-A- 49 061 595
- US-A1- 2004 051 055
- US-A1- 2004 124 365
- US-A1- 2011 284 744
- MOGREN S ET AL: "Field emission and photofield emission energy distributions from LaB6", SURFACE SCIENCE, vol. 254, no. 1-3, 2 août 1991 (1991-08-02), pages 169-181, XP025849185, NORTH-HOLLAND ISSN: 0039-6028, DOI: 10.1016/0039-6028(91)90649-D [extrait le 1991-08-02]
- DONDERS P J ET AL: "An improved optical system for photofield emission", REVIEW OF SCIENTIFIC INSTRUMENTS, vol. 56, no. 11, 1 novembre 1985 (1985-11-01), pages 2074-2076, XP001414422, AIP, MELVILLE, NY, US ISSN: 0034-6748
- DATABASE WPI Week 201158 Thomson Scientific, London, GB; AN 2011-K61331 XP002685068, -& CN 102 136 521 A (WANG X) 27 juillet 2011 (2011-07-27)
- PETER HOMMELHOFF ET AL: "A Femtosecond Nanometer Free Electron Source", ARXIV.ORG, CORNELL UNIVERSITY LIBRARY, 201 OLIN LIBRARY CORNELL UNIVERSITY ITHACA, NY 14853, 26 July 2005 (2005-07-26), XP080202991, DOI: 10.1103/PHYSREVLETT.96.077401

## Description

La présente invention concerne un dispositif d'émission d'électrons et le procédé correspondant, un système comportant un tel dispositif d'émission, tel qu'un microscope électronique et l'utilisation d'un tel dispositif ou d'un tel procédé d'émission d'électrons.

En particulier, la présente invention s'applique au domaine des sources électroniques accélérées à haute tension destinées notamment à la microscopie électronique en transmission ou à balayage.

De façon connue, le principe de la microscopie électronique en transmission est d'utiliser un faisceau d'électrons à la place du faisceau de lumière utilisé en microscopie optique. La longueur d'onde associée au faisceau d'électrons permet d'obtenir une résolution en microscopie électronique nettement supérieure à celle obtenue en microscopie optique.

Toutefois, des contraintes sont liées à l'utilisation des électrons. Il convient notamment d'avoir un vide poussé à l'intérieur du microscope électronique.

En outre et afin d'effectuer de la microscopie électronique en transmission, les échantillons utilisés doivent être ultraminces afin d'être aussi transparents que possible aux électrons. Un faisceau d'électrons est alors focalisé sur l'échantillon à observer par l'intermédiaire de lentilles électromagnétiques.

Dans le cas de la microscopie électronique en transmission, seuls les électrons traversant l'échantillon sont analysés. On distingue alors trois types d'électrons : les électrons transmis qui n'ont pas interagi avec l'échantillon, les électrons diffusés sans perte d'énergie suite à une interaction avec les atomes de l'échantillon et les électrons diffusés avec perte d'énergie suite à l'interaction des électrons incidents avec les cortèges électroniques des atomes de l'échantillon. L'utilisation des faisceaux d'électrons transmis et des faisceaux d'électrons diffusés permet de créer le contraste des images obtenues en microscopie électronique en transmission, notée MET.

Il y a deux principales familles de canon à électrons : les canons à électrons à cathode chaude et les canons à électrons à cathode froide.

Dans cette seconde famille de canons à électrons, dits « canons à électrons à cathode froide » et également appelés « canons à émission de champ froid » (et parfois simplement « canons à émission de champ » par abus de langage), des électrons sont arrachés par effet tunnel à une fine pointe métallique, généralement en tungstène, ladite pointe métallique étant soumise à un champ électrique élevé de l'ordre du GV/m. La pointe métallique n'est pas chauffée, aucun courant électrique ne passe dans ladite pointe et celle-ci est par exemple reliée à la masse flottante de la haute tension; il en résulte que la pointe est maintenue sensiblement à température ambiante. Les électrons ainsi arrachés sont ensuite accélérés par une tension d'accélération appliquée entre la cathode et une anode, la tension d'accélération étant de l'ordre de 100 kV. Dans les microscopes électroniques à haute résolution, cette tension d'accélération atteint parfois 300 kV. De manière similaire, on désigne par « cathode froide », l'extrémité de la pointe formant la cathode d'un tel dispositif.

De manière générale, une telle source d'électrons à cathode froide, où les électrons sont arrachés par effet tunnel, présente une faible dispersion énergétique. En outre, une telle source à émission de champ froid est quasiment ponctuelle. Elle présente alors une brillance et une cohérence spatiale bien plus élevées que les sources à cathode chaude.

Cependant, ces sources à cathode froide nécessitent un vide extrêmement poussé. Sans la présence de ce vide, la pointe du canon s'oxyde et l'effet d'émission s'atténue.

Il existe également des variantes de canons à électrons, par exemple les canons à émission de champ thermo-assistés ainsi que des canons à effet de champ dit canons Schottky utilisant des cathodes en Tungstène avec réservoir de Zircone. Ce dernier type de canons reste un bon compromis entre les sources incohérentes thermoïoniques et les sources cohérentes à émission de champ froide, mais ne présente pas tous les avantages des canons à électrons à cathode froide.

Les documents DE 196 04 272 A1 et US 2004/0124365 A1 divulguent des modes de réalisation de canons à émission de champ thermo-assisté ou de canons à effet de champ dit canons Schottky. Un faisceau de photons assiste l'émission des électrons. Dans ces dispositifs la pointe métallique est chauffée, et une partie significative des électrons émis résultent de cet effet thermique. Ces dispositifs ne constituent donc pas des canons à électrons à cathode froide. On note également que de tels dispositifs ne permettent pas d'obtenir une source d'électrons avec une brillance aussi grande et une cohérence spatiale aussi bonne que celles obtenues avec un canon à électrons à cathode froide.

Dans le domaine de l'holographie électronique, et notamment l'holographie en champ sombre, des performances en termes notamment de brillance et de cohérence sont nécessaires. Les sources d'électrons à émission de champ froid sont les mieux adaptées.

Jusqu'à ce jour, différentes stratégies ont été utilisées pour étudier par microscopie électronique des processus dynamiques. Selon l'échelle de temps du processus étudié, on distingue traditionnellement deux approches : la microscopie électronique in-situ et la microscopie électronique dynamique.

Basée sur l'interfaçage du microscope électronique avec une caméra vidéo, la microscopie in-situ permet d'obtenir des images avec un temps d'exposition et des intervalles entre images successives de l'ordre de la milliseconde.

Or, de nombreux processus en physique, science des matériaux, chimie et biologie ont des durées caractéristiques incompatibles avec les taux d'acquisition vidéo.

Les techniques de microscopie électronique à transmission dynamique (DTEM selon l'acronyme anglais pour *"Dynamic Transmission Electron Microscope*"), spécifiquement dédiées à l'étude de ces phénomènes ultrarapides ont connu plusieurs étapes de développement depuis les années 1970. Au début des années 1980 a été mise au point la technique de diffraction électronique ultrarapide qui utilise une source d'électrons constituée d'une photocathode couplée à un laser impulsionnel. Le principe d'une photocathode pulsée est d'émettre des impulsions d'électrons ultrabrèves par effet photoélectrique, l'onde électromagnétique fournissant aux électrons une énergie au moins égale au travail de sortie du matériau constituant la photocathode. A la fin des années 1980, l'implémentation d'une photocathode pulsée dans un microscope électronique en transmission a été démontrée. Ces développements ont abouti à des instruments disposant d'une résolution temporelle de l'ordre de la nanoseconde et d'une résolution spatiale de l'ordre de la centaine de nanomètres.

En microscopie électronique dynamique, on distingue deux modes d'acquisition distincts : mono coup ou stroboscopique.

Dans l'approche « mono coup », une observation par MET, synchronisée avec une excitation de l'échantillon, est réalisée au moyen d'un seul paquet d'électrons. Le nombre important d'électrons requis pour faire une image et les effets de charge d'espace et de répulsion coulombienne limitent actuellement la résolution spatiale dans ce mode de fonctionnement.

L'approche stroboscopique consiste à observer un objet qui évolue de façon périodique dans le temps à un instant précis à l'intérieur de chaque période. Cette seconde approche du DTEM a été récemment améliorée par A. Zewail et al. (Four Dimensional Electron Tomography, Science, 2010, 328, 187-193) en s'inspirant des expériences de spectroscopie optique ultrarapide utilisées en femtochimie. Ainsi, l'objet à étudier est excité cycliquement par des impulsions lasers ultrabrèves dites « pompe » prélevées sur le train d'impulsion d'un laser femtoseconde à haute cadence de répétition (MHz-GHz). L'autre partie de ce train d'impulsions est focalisée sur la photocathode pour déclencher l'émission d'un paquet d'électrons ultrabrefs « sonde » qui permettra d'observer l'échantillon par MET (imagerie, diffraction ou perte d'énergie d'électrons). Chacune des impulsions électroniques ne contient qu'un faible nombre d'électrons au niveau de l'échantillon étudié (1-1000) et un grand nombre d'impulsions sont donc intégrées sur le détecteur pour obtenir un rapport signal sur bruit satisfaisant. En maîtrisant au moyen d'une ligne à retard l'écart temporel entre impulsions pompe et sonde, il est possible d'étudier l'objet à différents instants de son cycle. Cette solution basée sur le déclenchement de l'émission électronique au moyen d'impulsions laser femtosecondes intenses focalisées sur une photocathode permet aujourd'hui d'obtenir une résolution temporelle subpicoseconde en DTEM.

Toutefois, les défauts intrinsèques des photocathodes pulsées, tels que de faibles cohérence spatiale et temporelle et une brillance très réduite, limitent les résolutions spatiale et énergétique qu'il est possible d'obtenir en les utilisant dans un MET. En outre, ces limitations empêchent catégoriquement leur utilisation pour des expériences d'interférométrie électronique ou de diffraction électronique cohérente.

Le but de la présente invention est de fournir un dispositif d'émission d'électrons palliant au moins partiellement les inconvénients précités.

Plus particulièrement, l'invention vise à fournir un dispositif d'émission d'électrons adapté pour émettre des impulsions électroniques de durée subpicoseconde et accélérées à très haute tension notamment pour les domaines de la microscopie et de l'interférométrie électroniques.

A cet effet et selon un premier aspect, l'invention propose un dispositif d'émission d'électrons par effet de champ selon la revendication 1, comprenant :
- une enceinte sous vide comportant une pointe comprenant une extrémité et formant une cathode froide, une anode extractrice, des composants adaptés pour générer une différence de potentiel entre la pointe et l'anode ;
- une source d'onde électromagnétique extérieure à l'enceinte ;
- un système d'acheminement de l'onde électromagnétique émise par la source d'onde électromagnétique de l'extérieur vers l'intérieur de l'enceinte jusqu'au voisinage de la pointe ;
- un système de focalisation de l'onde électromagnétique agencé à l'intérieur de l'enceinte ; et
- un système d'alignement de l'onde électromagnétique agencé à l'extérieur de l'enceinte et adapté pour permettre l'alignement de l'onde électromagnétique focalisée par le système de focalisation sur l'extrémité de la pointe,
le système de focalisation comprenant un miroir plan et un miroir parabolique ou sphérique disposés de part et d'autre de la pointe, chaque miroir étant connecté au même potentiel électrique que la pointe, le système d'acheminement étant adapté pour acheminer l'onde électromagnétique depuis le côté de la pointe opposée à l'anode extractrice jusqu'au voisinage de l'extrémité, de sorte qu'une onde électromagnétique émise par la source, alignée par le système d'alignement, acheminée par le système d'acheminement depuis l'arrière de la pointe, et focalisée par le système de focalisation, soit propagée jusqu'au niveau de l'extrémité de la pointe selon un angle compris entre 45° et 135°, de préférence sensiblement perpendiculairement à l'axe de la pointe. Un tel dispositif d'émission d'électrons appartient à la famille des dispositifs à canons à électrons à cathode froide, c'est-à-dire où les électrons sont arrachés par effet tunnel, et permet d'assurer une émission d'électrons par effet de champ pulsée ultrarapide.

Suivant des modes de réalisation préférés, le dispositif d'émission d'électrons selon l'invention comprend une ou plusieurs des caractéristiques suivantes, prises séparément ou en combinaison :
- le système d'acheminement comprend un hublot d'entrée adapté pour transmettre l'onde électromagnétique de l'extérieur vers l'intérieur de l'enceinte et un tube creux adapté pour propager l'onde électromagnétique dans l'enceinte jusqu'au voisinage de l'extrémité de la pointe, le tube étant en matériau ayant une rigidité diélectrique sensiblement compris entre 10 et 40 kV/mm ;
- le hublot d'entrée est en céramique transparente aux longueurs d'onde de l'onde électromagnétique émise par la source ;
- le système d'alignement comprend deux miroirs de balayage et un système optique, par exemple télescopique ou télécentrique;
- le système d'alignement est adapté pour réaliser un balayage de l'onde électromagnétique focalisée d'au moins 0,5 mm dans chacune des trois dimensions autour de la pointe ;
- la pointe est choisie parmi la liste consistant en :
   ◆ une pointe en tungstène orientée suivant différents axes cristallographiques ;
   ◆ une pointe en forme de cône en matériau comportant du carbone ;
   ◆ une pointe en or ;
- la source d'onde électromagnétique est un laser et notamment un laser femtoseconde.
Selon un deuxième aspect, l'invention concerne également un système comprenant au moins un dispositif d'émission d'électrons tel que décrit précédemment, le système étant choisi dans la liste consistant en :
- un microscope électronique en transmission ou à balayage,
- un dispositif de diffraction électronique ultra-rapide,
- un système de lithographie électronique.

Par ailleurs, selon un troisième aspect, l'invention concerne un microscope électronique comportant un dispositif d'émission d'électrons tel que décrit précédemment, une colonne comportant des composants d'optique électronique et des moyens d'accélération des électrons émis par le dispositif d'émission d'électrons.

Suivant des modes de réalisation préférés, les moyens d'accélération des électrons sont adaptés pour générer une tension d'accélération comprise entre quelques kV et quelques MV.

En outre l'invention concerne, selon un quatrième aspect, un procédé d'émission d'électrons par effet de champ comprenant les étapes suivantes :
- fournir un dispositif d'émission d'électrons tel que décrit précédemment ;
- émission d'une onde électromagnétique à l'extérieur de l'enceinte par la source d'onde électromagnétique du dispositif d'émission d'électrons ;
- propagation de l'onde électromagnétique émise vers l'intérieur de l'enceinte jusqu'au voisinage de la pointe ;
- focalisation de l'onde électromagnétique à l'intérieur de l'enceinte sur la pointe ; et
- alignement de l'onde électromagnétique focalisée sur la pointe, l'étape d'alignement étant réalisée depuis l'extérieur de l'enceinte.

Par ailleurs, selon un cinquième aspect, l'invention propose une utilisation du dispositif d'émission d'électrons ou du procédé d'émission d'électrons tels que décrits précédemment pour émettre des électrons de façon contrôlée par la source d'onde électromagnétique.

D'autres caractéristiques et avantages de l'invention apparaîtront à la lecture de la description qui suit d'un mode de réalisation préféré de l'invention, donnée à titre d'exemple et en référence aux dessins annexés :
- la figure 1 représente un schéma synoptique d'un dispositif d'émission d'électrons selon l'invention ;
- la figure 2 est un schéma synoptique de perspective et en coupe d'un mode de réalisation d'un système d'acheminement de l'onde électromagnétique du dispositif d'émission d'électrons de la figure 1 ;
- la figure 3 est un schéma synoptique de perspective d'un mode de réalisation d'un système de focalisation de l'onde électromagnétique du dispositif d'émission d'électrons de la figure 1 ;
- la figure 4 est un schéma synoptique en coupe du système de focalisation de la figure 3 en fonctionnement ; et
- la figure 5 illustre un schéma synoptique d'une source de microscope électronique comportant un dispositif d'émission d'électrons selon l'invention.

Sur les différentes figures, les éléments analogues sont désignés par des références identiques. En outre, les différents éléments ne sont pas nécessairement représentés à l'échelle afin de présenter une vue permettant de faciliter la compréhension de l'invention.

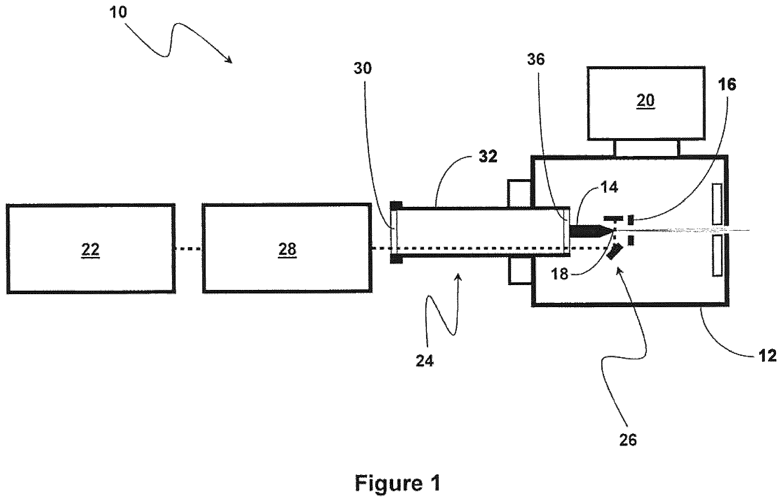

La figure 1 illustre un dispositif d'émission d'électrons 10 par effet de champ froid selon l'invention. Le dispositif d'émission d'électrons 10 comprend une enceinte 12 sous vide comportant une pointe 14 et une anode extractrice 16.

L'anode extractrice 16 est par exemple une plaque métallique polarisée positivement.

La pointe 14, qui forme une cathode froide, comprend une extrémité 18 appelée apex. Elle est métallique et préparée en forme de pointe très fine.

Par exemple, la pointe 14 est une pointe en tungstène orientée suivant différents axes cristallographiques, une pointe en forme de cône en matériau comportant du carbone, pointe en or.

Le rayon de courbure de l'apex de la pointe formant une cathode froide est de préférence inférieur ou égal à 50 nm permettant d'obtenir un champ électrique suffisant par effet de pointe.

Le dispositif d'émission d'électrons 10 par effet de champ froid implique que la pointe 14 n'est pas chauffée lorsque celle-ci est en fonctionnement.

De façon connue, l'apex de la cathode est placé à une distance optimisée comprise entre 1 et 15 mm de l'anode extractrice 16.

En outre, le dispositif d'émission d'électrons 10 comporte un système de pompage 20 relié à l'enceinte 12 et adapté pour générer un vide à l'intérieur de l'enceinte, par exemple un ultra vide poussé, dont la pression est sensiblement égale à 10⁻⁹ Pa. Bien entendu, l'enceinte 12 est en matériau adapté pour supporter un tel vide.

Par exemple, le système de pompage 20 comporte une ou plusieurs pompes ioniques et/ou une ou plusieurs pompes à fixation situées près de la cathode 14. De façon connue, une pompe à fixation appelée couramment pompe NEG (selon l'acronyme anglais pour *"Non Evaporate Getter*") comporte des matériaux non évaporables dit *"getter"* adaptés pour améliorer le pompage dynamique lorsque dans le cas particulier décrit ici le dispositif d'émission d'électrons est en fonctionnement.

De plus, le dispositif d'émission d'électrons 10 comporte en outre des composants, non représentés sur la figure 1, adaptés pour générer une différence de potentiel électrique entre la pointe 14 et l'anode extractrice 16.

En outre, le dispositif d'émission d'électrons 10 peut comporter un système de nettoyage de la cathode adapté pour générer et faire circuler dans la pointe 14 un faible courant, couramment appelé *"Flash".* Un tel système de nettoyage permet notamment de diminuer la contamination de la cathode.

De plus, le dispositif d'émission d'électrons 10 peut comporter un système de nettoyage de l'anode extractrice 16, par exemple un système de dégazage de l'anode extractrice, placé au voisinage de la pointe lors de l'étuvage complet du dispositif d'émission d'électrons 10. Par exemple, le système de dégazage comporte des résistances chauffantes, des lampes halogènes voire des filaments de tungstène qui émettent des doses importantes d'électrons vers la face de l'anode extractrice en regard de la pointe.

Le dispositif d'émission d'électrons 10 comprend en outre une source 22 d'onde électromagnétique extérieure à l'enceinte 12. La source d'onde électromagnétique 22 est ultra-rapide, c'est-à-dire adaptée pour générer des impulsions d'onde électromagnétique ultra-brèves dont la durée est sensiblement inférieure à 1 ps.

De préférence, l'onde électromagnétique émise par la source d'onde électromagnétique 22 a une longueur d'onde comprise entre 0,1 µm et 8 µm.

Par exemple, la source d'onde électromagnétique 22 est un laser et notamment un laser femtoseconde, tel qu'un laser femtoseconde dont la longueur d'onde d'émission est comprise entre l'infrarouge et l'ultraviolet.

En outre, la source d'onde électromagnétique 22 comporte un moyen de réglage de la polarisation du faisceau électromagnétique émis par la source 22, ce moyen de réglage étant agencé à l'extérieur de l'enceinte 12.

Le dispositif d'émission d'électrons 10 comporte en outre un système d'acheminement 24 de l'onde électromagnétique émise par la source d'onde électromagnétique 22 de l'extérieur vers l'intérieur de l'enceinte 12 jusqu'au voisinage de la pointe 14. Le système d'acheminement 24 de l'onde électromagnétique de l'extérieur vers l'intérieur de l'enceinte est adapté pour acheminer l'onde électromagnétique depuis l'arrière de la pointe 14, c'est-à-dire du côté opposé à l'anode extractrice 16, jusqu'au voisinage de l'apex 18 de la pointe 14.

Un tel système d'acheminement par l'arrière de la pointe permet de ne pas modifier les éléments d'un microscope électronique en transmission standard situés sous la pointe tels que l'anode extractrice, l'anode adaptée pour focaliser les électrons dite *"gun-lens",* les moyens d'accélération des électrons émis, la colonne et les détecteurs et permettant ainsi de garder ses propriétés optiques remarquables inchangées.

De plus, le dispositif d'émission d'électrons 10 comporte un système de focalisation 26 de l'onde électromagnétique sur l'extrémité 18 de la pointe 14 agencé à l'intérieur de l'enceinte 12 et un système d'alignement 28 de l'onde électromagnétique agencé à l'extérieur de l'enceinte 12 et adapté pour permettre l'alignement de l'onde électromagnétique focalisée par le système de focalisation 26 sur l'extrémité 18 de la pointe 14.

L'ensemble formé par la source d'onde électromagnétique 22, le système d'acheminement 24, le système de focalisation 26 et le système d'alignement 28 est adapté pour propager l'onde électromagnétique de sorte qu'elle arrive au niveau de l'extrémité 18 de la pointe 14 perpendiculairement à l'axe de la cathode 14.

Un tel ensemble permet que la polarisation de l'onde électromagnétique arrivant sur la pointe soit parallèle à la direction d'émission des électrons, c'est-à-dire à l'axe de la pointe.

Il convient de noter que si cette disposition géométrique dudit ensemble correspond à un mode de réalisation particulièrement avantageux, il est possible de mettre en oeuvre la présente invention avec une disposition géométrique dudit ensemble différente, où l'ensemble formé par la source d'onde électromagnétique 22, le système d'acheminement 24, le système de focalisation 26 et le système d'alignement 28 est adapté pour propager l'onde électromagnétique de sorte qu'elle arrive au niveau de l'extrémité 18 de la pointe avec un angle compris entre 45° et 135° par rapport à l'axe de pointe 14. Dans ces cas, la polarisation de l'onde électromagnétique arrivant sur la pointe n'est pas perpendiculaire à l'axe de la pointe. L'effet obtenu est proportionnel au cosinus carré de l'angle entre la polarisation de l'onde électromagnétique arrivant sur la pointe et l'axe de la pointe. Un homme du métier est susceptible de choisir un angle approprié en fonction de l'effet recherché.

A cet effet, le système d'acheminement, le système de focalisation et le système d'alignement vont maintenant être décrit en détails.

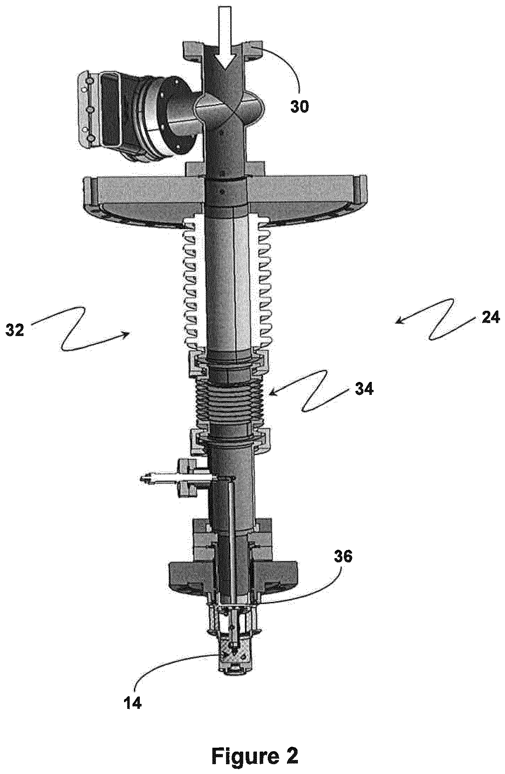

La figure 2 illustre de manière plus détaillée un mode de réalisation d'un système d'acheminement 24 de l'onde électromagnétique du dispositif d'émission d'électrons de la figure 1.

Le système d'acheminement 24 comprend un premier hublot 30, un tube creux 32 et un deuxième hublot 36, appelé par la suite, hublot d'entrée 36. Le tube creux 32 est agencé entre le premier hublot 30 et le hublot d'entrée 36.

Le premier hublot 30 est adapté pour transmettre l'onde électromagnétique émise par la source d'onde électromagnétique 22 de l'extérieur vers l'intérieur du tube 32. Il est en verre traditionnel transparent aux longueurs d'onde de l'onde électromagnétique émise par la source d'onde électromagnétique 22.

Le tube creux 32 est adapté pour propager l'onde électromagnétique dans l'enceinte 12 jusqu'au voisinage de l'extrémité 18 de la pointe 14.

De manière préférée, le tube creux 32 est en matériau ayant une rigidité diélectrique sensiblement compris entre 10 et 40 kV/mm. Notamment, le tube est en alumine ultra pure. Un tel choix de matériau permet d'isoler électriquement les éléments du dispositif d'émission 10 situés en amont du tube creux 32 et dont le potentiel est à la terre, de la région autour de la pointe 14, située en aval du tube creux 32, dont le potentiel moyen est flottant à la haute tension d'accélération négative (-HT). Les termes amont et aval s'entendent par rapport au sens de propagation de l'onde électromagnétique émise par la source d'onde électromagnétique 22 jusqu'à la pointe 14.

En outre, le matériau ainsi que la forme du tube sont judicieusement choisis afin de minimiser la longueur du tube. Par exemple, pour une source fonctionnant à 200 kV, un tube en céramique alumine ultra pure taillée avec des lignes de fuites adaptées pour augmenter la surface de zone isolante sans augmenter la longueur, permet avantageusement de réduire la longueur du tube à 10 cm pour un encombrement minimisé.

Le système d'acheminement 24 comprend en outre un dispositif de pompage (non représenté) relié au tube creux 32 et adapté pour générer et maintenir un vide standard (de l'ordre de 10⁻⁷ Pa) à l'intérieur du tube creux 32.

Un tel système d'acheminement dont l'intérieur du tube est maintenu sous vide permet une propagation libre du faisceau électromagnétique. Cela permet de minimiser l'influence de la traversée d'un milieu matériel (dispersion, automodulation de phase) sur les caractéristiques des impulsions électromagnétiques et donc de minimiser leur allongement temporel.

Un tel système d'acheminement comportant des céramiques isolantes et transparentes aux longueurs d'onde de l'onde électromagnétique émise par la source d'onde électromagnétique 22 permet au faisceau électromagnétique ultra rapide de passer de l'extérieur de l'enceinte 12 à l'intérieur de l'enceinte 12 en zone ultra vide (UHV) tout en maintenant l'isolation électrique entre la pointe 14 et l'anode extractrice 16 mais aussi entre la zone flottante à -HT et les zones à la terre.

Le hublot d'entrée 36 est adapté pour transmettre l'onde électromagnétique acheminée par le tube creux 32 vers la pointe 14 dans un environnement UHV, notamment de l'extérieur vers l'intérieur de l'enceinte 12. Il est en matériau transparent aux longueurs d'onde de l'onde électromagnétique émise par la source d'onde électromagnétique 22. De manière préférée, il est en céramique et notamment en céramique à base d'alumine afin d'isoler la tension d'extraction maintenue entre la pointe 14 et l'anode extractrice 16.

Un tel agencement de hublot d'entrée 36 à l'extrémité avale du tube creux 32 permet de transférer le faisceau électromagnétique de la zone maintenue sous vide standard (10⁻⁷ Pa) à la zone ultra vide (10⁻⁹ Pa) nécessaire au bon fonctionnement de la source à émission de champ.

Une telle réalisation d'un système d'acheminement 24 permet la propagation libre sous vide d'une onde électromagnétique de l'extérieur de l'enceinte à la zone flottante à la haute tension d'accélération.

Une variante plus simple d'un système d'acheminement est envisageable pour des applications telles que la microscopie électronique à balayage, la lithographie... Selon cette variante, le système d'acheminement est dépourvu de tube creux et comporte un unique hublot en céramique transparente identique au hublot d'entrée 36 du mode de réalisation décrit ci-avant.

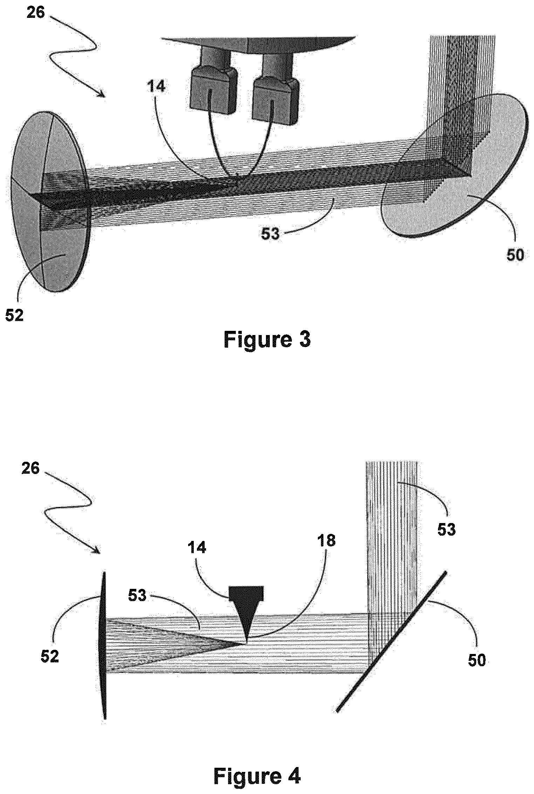

En regard des figures 3 et 4, le système de focalisation 26 de l'onde électromagnétique comprend un miroir plan 50 et un miroir parabolique ou sphérique 52 disposés de part et d'autre de la pointe 14. Le miroir parabolique ou sphérique 52 est agencé à une distance de l'extrémité 18 de la pointe 14 sensiblement égale à sa distance focale permettant ainsi de régler la taille de la tache focale et donc la densité de puissance disponible pour déclencher l'émission des électrons.

Chaque miroir 50, 52 est connecté au même potentiel diélectrique (-HT) que la pointe 14. Cela permet notamment d'éviter les décharges disruptives et les problèmes liés au vide.

En outre, chaque miroir est couplé mécaniquement à la pointe 14, c'est-à-dire fixé à un support solidaire de la pointe 14, permettant de conserver l'alignement, préalablement réglé, des miroirs 50, 52 par rapport à la pointe 14 au cours de l'alignement de la pointe 14 par rapport au centre de l'anode extractrice 16.

En outre, chaque miroir 50, 52 a une surface réfléchissante traitée avec des matériaux à faible dégazage et possédant un coefficient de réflexion maximum à la longueur d'onde du faisceau électromagnétique émis par la source d'onde électromagnétique 22.

En fonctionnement, le faisceau électromagnétique, noté 53, acheminé par le système d'acheminement 24 est réfléchi par le miroir plan 50 en direction du miroir parabolique ou sphérique 52 qui le réfléchit à son tour en direction de l'extrémité de la pointe et le focalise sur l'extrémité de la pointe 14.

Bien entendu, d'autres systèmes de focalisation comportant des optiques réflectives peuvent également être utilisés, par exemple de type Cassegrain.

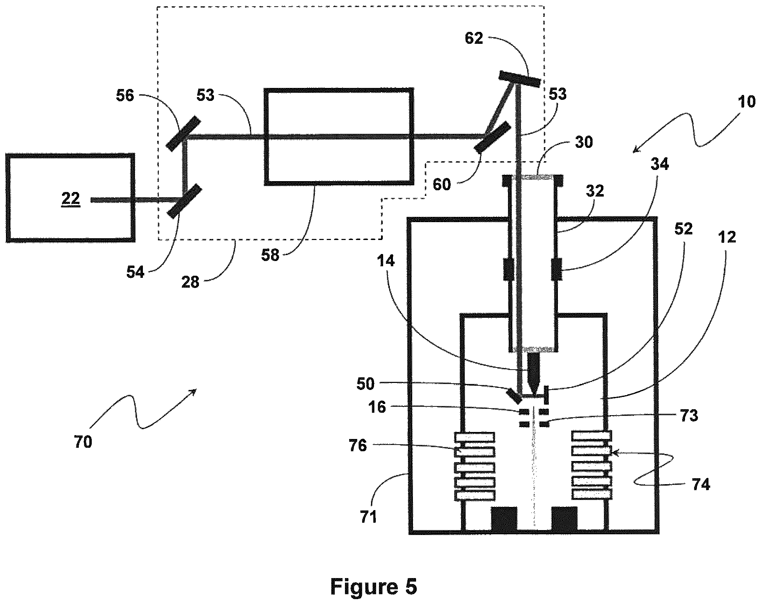

La figure 5 illustre une source de microscope électronique 70 comportant un dispositif d'émission d'électrons 10 selon l'invention.

En regard de la figure 5, le système d'alignement 28 comprend deux miroirs de balayage 54, 56, un système optique 58, par exemple télescopique ou télécentrique, et deux miroirs plans 60, 62, chacun agencés à l'extérieur de l'enceinte.

Le système optique 58, par exemple télescopique ou télécentrique, est agencé entre l'ensemble formé par les deux miroirs de balayage 54, 56 et l'ensemble formé par les deux miroirs plans 60, 62.

Le système d'alignement 28 est adapté pour réaliser un balayage de l'onde électromagnétique focalisée d'au moins 0,5 mm dans chacune des trois dimensions autour de la pointe.

A cet effet, les miroirs plans 60, 62 sont adaptés pour aligner grossièrement le faisceau électromagnétique tandis que les miroirs de balayage 54, 56 sont adaptés pour ajuster précisément l'alignement du faisceau électromagnétique.

Les lentilles du système 58 optique, par exemple télescopique ou télécentrique, ainsi que les miroirs plans 60, 62 sont ajustables les uns par rapport aux autres en position grâce à des supports d'alignements mécaniques précis.

En outre, une des lentilles du système optique 58, par exemple télescopique ou télécentrique, est placée sur une platine de translation. Les miroirs de balayage 54, 56 sont agencés pour déplacer le spot du faisceau électromagnétique focalisé sur la pointe dans un plan perpendiculaire au faisceau électromagnétique (défini par une première et une seconde directions perpendiculaires entre elles) et la lentille placée sur une platine de translation est agencée pour déplacer le spot selon une troisième direction perpendiculaire aux deux premières.

Un tel système d'alignement 28 permet ainsi d'ajuster la position et l'orientation des différents composants optiques 54, 56, 58, 60, 62, 50, 52 placés sur le trajet optique du faisceau électromagnétique afin d'une part de focaliser le faisceau électromagnétique sur l'extrémité de la pointe et de pouvoir réaliser un balayage tridimensionnel du faisceau depuis l'extérieur de l'enceinte comportant la pointe.

En outre, cet ajustement de position du faisceau focalisé sur l'extrémité de la pointe est réalisé tout en permettant le fonctionnement du dispositif d'émission d'électrons (UHV, haute tension d'accélération, tension d'extraction). Un tel système d'alignement 28 apporte ainsi une flexibilité dans l'optimisation des conditions d'émission des électrons.

Une telle réalisation d'un dispositif d'émission d'électrons permet ainsi d'asservir le courant d'émission des électrons à la position de la tache focale, c'est-à-dire à la position des différents éléments optiques du système d'alignement 28 permettant ainsi de maximiser le rendement de l'émission.

En outre, le système de focalisation 26 peut comporter un système de réglage (non représenté) de l'orientation et de la position de chaque miroir 50, 52. Par exemple, le système de réglage est un système de centrage mécanique ou des piezotubes fonctionnant selon un mouvement de translation du type collé-glissé (« *stick-slip* » en anglais). Dans ce cas, le système de réglage nécessite d'être au même potentiel flottant de la haute tension d'accélération lors de la mise en fonctionnement du dispositif d'émission d'électrons.

En fonctionnement, la source d'onde électromagnétique 22 émet une onde électromagnétique qui se propage à l'extérieur de l'enceinte 12 à travers d'une part le système d'alignement 28 et d'autre part le système d'acheminement 24. Grâce au système d'acheminement, l'onde électromagnétique passe de l'extérieur vers l'intérieur de l'enceinte 12 en pénétrant successivement dans une zone de vide standard dans le tube creux 32 à une zone d'ultra vide à proximité de la pointe 14.

Ensuite, le faisceau électromagnétique est focalisé par le système de focalisation sur l'extrémité de la pointe formant cathode froide. En outre, la polarisation du faisceau électromagnétique est parallèle à la direction d'émission des électrons *i.e.* à la pointe.

Un champ électrique intense est appliqué sur l'apex de la cathode 14 placée à une distance optimisée de l'anode extractrice 16. Plus la tension de polarisation de l'anode 16, appelée tension d'extraction, est importante, plus ce champ sera intense. De même, plus l'apex de la cathode 14 est fin, plus le champ électrique est intense. Lorsque ce dernier est suffisant, les électrons sont extraits de la pointe 14 métallique vers l'extérieur par effet tunnel, appelé effet de champ dans ce cas précis.

Selon l'invention, l'extraction des électrons est déclenchée par le faisceau électromagnétique focalisé sur l'apex 18 de la cathode 14. L'émission des électrons par effet de champ étant quasi-instantanée, l'invention permet d'obtenir des impulsions électroniques de durée comparable voire meilleure que celle de l'impulsion électromagnétique utilisée pour le déclenchement.

En effet, l'extraction des électrons est favorisée par le faisceau électromagnétique focalisé sur la pointe et ayant une polarisation parallèle à la direction d'émission des électrons. Ainsi, l'émission de champ se fait par émission de champ assistée par l'absorption de un ou plusieurs photons ou par émission de champ optique selon la densité de puissance de l'onde électromagnétique au niveau de l'apex 18 de la pointe 14 et selon le type de matériau constituant la pointe 14.

L'émission des électrons est déclenchée par le faisceau électromagnétique focalisé sur l'apex tout en gardant les propriétés de brillance exceptionnelle d'une cathode à émission de champ froide standard, en raison de la petite zone d'émission des électrons.

Ainsi, le dispositif d'émission d'électrons selon l'invention délivre des impulsions ultra-brèves par émission de champ assistée par une onde électromagnétique ultrarapide.

Le dispositif d'émission d'électrons ci-dessus est adapté pour mettre en oeuvre un procédé d'émission d'électrons et notamment un procédé d'émission d'électrons selon l'invention et tel que décrit ci-après.

Un procédé d'émission d'électrons selon l'invention comporte une étape de fourniture d'un dispositif d'émission d'électrons selon l'invention tel que décrit précédemment.

En outre, le procédé d'émission d'électrons comprend une étape d'émission d'une onde électromagnétique à l'extérieur de l'enceinte par la source d'onde électromagnétique du dispositif d'émission d'électrons. La polarisation de l'onde électromagnétique émise est ajustée depuis l'extérieur de l'enceinte 12, afin de contrôler son orientation par rapport à la pointe.

Puis l'onde électromagnétique émise se propage de l'extérieur vers l'intérieur de l'enceinte jusqu'au voisinage de la pointe.

L'onde électromagnétique est ensuite focalisée à l'intérieur de l'enceinte sur la pointe.

De plus, le procédé comporte une étape d'alignement de l'onde électromagnétique focalisée sur la pointe, l'étape d'alignement étant réalisée depuis l'extérieur de l'enceinte.

Cette étape d'alignement comprend une étape préalable de réglage du système de focalisation installé autour de la cathode sans application de la haute tension, par exemple à l'aide d'un système de centrage mécanique ou de piezotubes fonctionnant en « *stick-slip* » afin de ne pas les laisser polarisés lors de la montée en tension de l'accélérateur.

Une fois le centrage grossier des miroirs plan 50 et parabolique ou sphérique 52 situés près de la pointe effectué, la pointe est mise en place dans l'enceinte.

En outre, l'étape d'alignement comporte une étape d'alignement grossier du faisceau électromagnétique au moyen des deux miroirs plans 60, 62 suivie d'une étape d'ajustement précis de la position du faisceau électromagnétique focalisé sur la pointe de la cathode réalisée depuis l'extérieur de l'enceinte 12 grâce à l'utilisation combinée du système optique 58, par exemple télescopique ou télécentrique, et des miroirs de balayage 54, 56. En outre, un système d'alignement tel que décrit précédemment peut permettre d'automatiser l'étape d'alignement en asservissant le balayage du faisceau électromagnétique à l'intensité du courant d'électrons émis par la cathode afin de maximiser le rendement de l'émission.

En regard de la figure 5, la source de microscope électronique 70 comporte en outre une autre enceinte 71.

L'enceinte 12 sous UHV et sous haute tension est agencée à l'intérieur de cette autre enceinte 71, appelée par la suite enceinte externe 71.

L'enceinte externe 71 est adaptée pour isoler électriquement l'enceinte 12 sous UHV et sous haute tension de l'extérieur de l'autre enceinte 71. A cet effet, par exemple, l'enceinte externe 71 est remplie d'un gaz isolant sous pression notamment SF6.

Ainsi, les éléments du dispositif d'émission d'électrons 10 agencés à l'extérieur de l'enceinte externe 71, dont le potentiel est à la terre, sont isolés électriquement de la région autour de la pointe 14, dont le potentiel moyen est flottant à la haute tension d'accélération négative (-HT).

De plus, le système d'acheminement 24 comporte une liaison souple 34 entre le tube creux 32 et la pointe 14 fixé solidairement au hublot d'entrée 36.

En regard de la figure 2, la liaison souple 34 comporte un soufflet, notamment un soufflet formé de galettes soudées entre elles, adapté pour permettre un mouvement libre de la cathode 14 relativement à un ensemble formé par l'enceinte externe 71 et le tube creux 32.

En outre, la liaison souple 34 est agencée entre le tube creux 32 et le hublot d'entrée 36.

Un tel agencement de système d'acheminement 24 et d'enceinte externe 71 permet au faisceau électromagnétique de traverser la zone contenant le gaz isolant sous pression sans modification des propriétés du faisceau et tout en autorisant un mouvement libre de la pointe 14 par rapport à l'enceinte externe 71.

Selon un autre aspect, l'invention concerne tout système comprenant au moins un dispositif d'émission d'électrons 10 tel que décrit ci-avant.

En particulier, le système est un microscope électronique en transmission ou à balayage, un dispositif de diffraction électronique ultra-rapide, ou un système de lithographie électronique.

Le cas où le système est une source de microscope électronique en transmission est décrit en regard de la figure 5.

Dans le cas où le système est un microscope électronique, celui-ci comporte une source d'électrons 70 telle qu'illustrée sur la figure 5, une colonne et des détecteurs tels qu'une caméra par exemple.

De façon connue, la colonne comporte des composants d'optique électronique notamment adaptés pour former une image.

Notamment, la colonne comporte des lentilles condenseur, une lentille objectif, l'objet à étudier, les lentilles intermédiaires et les lentilles projecteur.

La source de microscope électronique en transmission 70 comporte, en regard de la figure 5, un dispositif de focalisation du faisceau d'électrons émis par le dispositif d'émission d'électrons 10. Le dispositif de focalisation est agencé à l'intérieur de l'enceinte 12 en aval de l'anode extractrice 16. Il comporte une anode 73 adaptée pour focaliser les électrons et couramment appelée *"gun-lens".*

En outre, la source de microscope électronique en transmission 70 comprend des moyens d'accélération 74 des électrons émis par le dispositif d'émission d'électrons 10 agencés à l'intérieur de l'enceinte externe 71 et en aval du dispositif de focalisation. Le terme aval s'entend ici par rapport au sens de propagation des électrons extraits de la pointe 14.

Les moyens d'accélération 74 des électrons sont adaptés pour générer une tension d'accélération comprise entre quelques kV et quelques MV. Ils comportent une pluralité d'anodes 76 polarisées séparées par des céramiques isolantes. Les moyens d'accélération 74 sont agencés à l'intérieur de la colonne 72 après l'anode dite *"gun-lens"*dans le sens de propagation des électrons.

En fonctionnement, le dispositif d'émission d'électrons 10 émet des électrons selon par exemple le procédé décrit précédemment.

Puis, les électrons émis sont focalisés par une deuxième anode, appelée gun-lens puis accélérés par la succession d'anodes polarisées séparées par les céramiques isolantes. La tension d'accélération est généralement de l'ordre de 100 kV.

Les électrons sont accélérés afin de diminuer leur longueur d'onde et augmenter ainsi la résolution de l'instrument d'optique associé, ici un microscope électronique en transmission.

Le dispositif d'émission d'électrons selon l'invention repose sur le couplage d'une source d'onde électromagnétique avec une source d'électrons, à émission de champ froide à haute tension d'un système tel qu'un microscope électronique.

Ainsi, le dispositif d'émission d'électrons selon l'invention permet de délivrer des impulsions ultra-brèves à émission de champ assistée par une onde électromagnétique ultrarapide, une source laser femtoseconde dans le mode de réalisation décrit ici.

Le dispositif d'émission d'électrons aussi bien que le procédé d'émission d'électrons selon l'invention et décrits ci-avant peuvent ainsi être utilisés pour émettre des électrons de façon contrôlée par la source d'onde électromagnétique. La source d'onde électromagnétique permet de contrôler l'instant d'émission des électrons et/ou le nombre des électrons émis.

Un tel dispositif d'émission d'électrons accélérés à haute tension délivrant des impulsions électroniques ultrabrèves permet ainsi des études par microscopie électronique et interférométrie électronique résolue en temps avec une résolution temporelle sub-picoseconde. En effet, les techniques de la microscopie électronique en transmission cohérentes peuvent être directement transposées grâce à un tel dispositif d'émission d'électron par effet de champ selon l'invention, pour étudier des phénomènes dynamiques jusqu'à des résolutions temporelles subpicosecondes.

Cette source pourra en outre être utilisée pour générer des clichés de diffraction hors d'un microscope électronique en transmission (MET ou TEM en anglais). Ce type de technique est bien connu et est très utilisée pour étudier les évolutions structurales de nano-objets soumis à une dynamique ultra rapide sans les inconvénients provenant de la complexité technique d'un MET. De plus, l'utilisation d'un dispositif d'émission d'électrons par effet de champ selon l'invention, permet de combiner ces techniques de diffraction à des techniques d'interférométrie et ainsi de réaliser de la diffraction électronique cohérente.

Bien entendu, la présente invention n'est pas limitée aux exemples et au mode de réalisation décrits et représentés, mais elle est susceptible de nombreuses variantes accessibles à l'homme du métier.

## Revendications

1. Dispositif d'émission d'électrons (10) par effet de champ comprenant :
- une enceinte (12) sous vide comportant une pointe (14) comprenant une extrémité (18) et formant une cathode froide, une anode extractrice (16), des composants adaptés pour générer une différence de potentiel entre la pointe (14) et l'anode (16) ;
- une source d'onde électromagnétique (22) extérieure à l'enceinte (12) ;
- un système d'acheminement (24) de l'onde électromagnétique émise par la source d'onde électromagnétique de l'extérieur vers l'intérieur de l'enceinte jusqu'au voisinage de la pointe (14) ;
- un système de focalisation (26) de l'onde électromagnétique agencé à l'intérieur de l'enceinte (12) ; et
- un système d'alignement (28) de l'onde électromagnétique agencé à l'extérieur de l'enceinte et adapté pour permettre l'alignement de l'onde électromagnétique focalisée par le système de focalisation sur l'extrémité de la pointe,
le système de focalisation (26) comprenant un miroir plan (50) et un miroir parabolique ou sphérique (52) disposés de part et d'autre de la pointe (14), chaque miroir (50, 52) étant connecté au même potentiel électrique que la pointe (14), le système d'acheminement (24) étant adapté pour acheminer l'onde électromagnétique depuis le côté de la pointe (14) opposée à l'anode extractrice (16) jusqu'au voisinage de l'extrémité (18), de sorte qu'une onde électromagnétique émise par la source (22), alignée par le système d'alignement (28), acheminée par le système d'acheminement (24) depuis l'arrière de la pointe (14), et focalisée par le système de focalisation (26), soit propagée jusqu'au niveau de l'extrémité (18) de la pointe (14) selon un angle compris entre 45° et 135°, de préférence sensiblement perpendiculairement à l'axe de la pointe (14).

2. Dispositif d'émission d'électrons (10) selon la revendication précédente, dans lequel le système d'acheminement (24) comprend un hublot d'entrée (36) adapté pour transmettre l'onde électromagnétique de l'extérieur vers l'intérieur de l'enceinte (12) et un tube creux (32) adapté pour propager l'onde électromagnétique dans l'enceinte jusqu'au voisinage de l'extrémité de la pointe (14), le tube étant en matériau ayant une rigidité diélectrique sensiblement compris entre 10 et 40 kV/mm.

3. Dispositif d'émission d'électrons selon la revendication précédente, dans lequel le hublot d'entrée (36) est en céramique transparente aux longueurs d'onde de l'onde électromagnétique émise par la source (22).

4. Dispositif d'émission d'électrons selon l'une quelconque des revendications précédentes, dans lequel le système d'alignement (28) comprend au moins deux miroirs de balayage (54, 56) et un système optique (58), par exemple télescopique ou télécentrique.

5. Dispositif d'émission d'électrons selon l'une quelconque des revendications précédentes, dans lequel le système d'alignement (28) est adapté pour réaliser un balayage de l'onde électromagnétique focalisée d'au moins 0,5 mm dans chacune des trois dimensions autour de la pointe (14).

6. Dispositif d'émission d'électrons selon l'une quelconque des revendications précédentes, dans lequel la pointe (14) est choisie parmi la liste consistant en :
- une pointe en tungstène orientée suivant différents axes cristallographiques ;
- une pointe en forme de cône en matériau comportant du carbone ;
- une pointe en or.

7. Dispositif d'émission d'électrons selon l'une quelconque des revendications précédentes, dans lequel la source d'onde électromagnétique (22) est un laser et notamment un laser femtoseconde.

8. Système comprenant au moins un dispositif d'émission d'électrons selon l'une des revendications 1 à 7, le système étant choisi dans la liste consistant en :
- un microscope électronique en transmission ou à balayage,
- un dispositif de diffraction électronique ultra-rapide,
- un système de lithographie électronique.

9. Microscope électronique comportant un dispositif d'émission d'électrons (10) selon l'une des revendications 1 à 7, une colonne comportant des composants d'optique électronique et des moyens d'accélération (76) des électrons émis par le dispositif d'émission d'électrons.

10. Microscope électronique selon la revendication 9, dans lequel les moyens d'accélération (76) des électrons sont adaptés pour générer une tension d'accélération comprise entre quelques kV et quelques MV.

11. Procédé d'émission d'électrons par effet de champ comprenant les étapes suivantes :
- fournir un dispositif d'émission d'électrons selon l'une quelconque des revendications 1 à 7 ;
- émission d'une onde électromagnétique à l'extérieur de l'enceinte (12) par la source (22) d'onde électromagnétique du dispositif d'émission d'électrons ;
- propagation de l'onde électromagnétique émise vers l'intérieur de l'enceinte (12) jusqu'au voisinage de la pointe (14), par le système d'acheminement (24) ;
- focalisation de l'onde électromagnétique à l'intérieur de l'enceinte (12) sur la pointe (14) par le système de focalisation (26) ; et
- alignement de l'onde électromagnétique focalisée sur la pointe (14), l'étape d'alignement étant réalisée depuis l'extérieur de l'enceinte (2), par le système d'alignement (28).

12. Utilisation du dispositif d'émission d'électrons selon l'une des revendications 1 à 7 ou du procédé d'émission d'électrons selon la revendication 11 pour émettre des électrons de façon contrôlée par la source d'onde électromagnétique.

## Patentansprüche

1. Vorrichtung zum Emittieren von Elektronen (10) durch Feldeffekt, die Folgendes umfasst:
- ein Vakuumgehäuse (12), das Folgendes umfasst: eine Spitze (14), die ein Ende (18) aufweist und eine kalte Kathode bildet, eine Extraktionsanode (16), Komponenten, die zum Erzeugen einer Potentialdifferenz zwischen der Spitze (14) und der Anode (16) ausgelegt sind;
- eine Elektromagnetische-Wellen-Quelle (22) außerhalb des Gehäuses (12),
- ein System (24) zum Leiten der von der Elektromagnetische-Wellen-Quelle emittierten elektromagnetischen Welle von der Außenseite zur Innenseite des Gehäuses bis in die Nähe der Spitze (14);
- ein System (26) zum Fokussieren der elektromagnetischen Welle, das im Innern des Gehäuses (12) angeordnet ist; und
- ein System (28) zum Ausrichten der elektromagnetischen Welle, das auf der Außenseite des Gehäuses angeordnet und zum Ermöglichen des Ausrichtens der vom Fokussiersystem fokussierten elektromagnetischen Welle auf das Ende der Spitze ausgelegt ist,
wobei das Fokussiersystem (26) einen Planspiegel (50) und einen parabolischen oder sphärischen Spiegel (52) umfasst, die auf beiden Seiten der Spitze (14) angeordnet sind, wobei jeder Spiegel (50, 52) mit demselben elektrischen Potential verbunden ist wie die Spitze (14), wobei das Leitsystem (24) zum Leiten der elektromagnetischen Welle von der Seite der Spitze (14) gegenüber der Extraktionsanode (16) bis in die Nähe des Endes (18) ausgelegt ist, so dass eine von der Quelle (22) emittierte elektromagnetische Welle, ausgerichtet durch das Ausrichtsystem (28), geleitet durch das Leitsystem (24) vom hinteren Teil der Spitze (14) und fokussiert durch das Fokussiersystem (26), bis an das Ende (18) der Spitze (14) in einem Winkel zwischen 45° und 135°, vorzugsweise im Wesentlichen lotrecht zur Achse der Spitze (14) propagiert wird.

2. Elektronenemissionsvorrichtung (10) nach dem vorherigen Anspruch, bei der das Leitsystem (24) ein Eintrittsfenster (36) umfasst, ausgelegt zum Durchlassen der elektromagnetischen Welle von der Außenseite zur Innenseite des Gehäuses (12), und ein hohles Rohr (32), ausgelegt zum Propagieren der elektromagnetischen Welle in dem Gehäuse bis in die Nähe des Endes der Spitze (14), wobei das Rohr aus einem Material mit einer dielektrischen Steifigkeit im Wesentlichen zwischen 10 und 40 kV/mm ist.

3. Elektronenemissionsvorrichtung nach dem vorherigen Anspruch, bei der das Eintrittsfenster (36) aus Keramik ist, die für die Wellenlängen der von der Quelle (22) emittierten elektromagnetischen Welle transparent ist.

4. Elektronenemissionsvorrichtung nach einem der vorherigen Ansprüche, bei der das Ausrichtsystem (28) wenigstens zwei Abtastspiegel (54, 56) und ein optisches System (58), zum Beispiel teleskopisch oder telezentrisch, umfasst.

5. Elektronenemissionsvorrichtung nach einem der vorherigen Ansprüche, bei der das Ausrichtsystem (28) zum Realisieren einer Abtastung der auf wenigstens 0,5 mm fokussierten elektromagnetischen Welle in jeder der drei Dimensionen um die Spitze (14) ausgelegt ist.

6. Elektronenemissionsvorrichtung nach einem der vorherigen Ansprüche, bei der die Spitze (14) ausgewählt ist aus der Liste bestehend aus:
- einer Wolframspitze, die in unterschiedlichen kristallografischen Achsen orientiert ist;
- einer kegelförmigen Spitze aus einem kohlenstoffhaltigen Material;
- einer Goldspitze.

7. Elektronenemissionsvorrichtung nach einem der vorherigen Ansprüche, bei der die Elektromagnetische-Wellen-Quelle (22) ein Laser und insbesondere ein Femtosekundenlaser ist.

8. System, das wenigstens eine Elektronenemissionsvorrichtung nach einem der Ansprüche 1 bis 7 umfasst, wobei das System ausgewählt ist aus der Liste bestehend aus:
- einem Transmissions- oder Abtastelektronenmikroskop,
- einer ultraschnellen elektronischen Beugungsvorrichtung,
- einem elektronischen Lithografiesystem.

9. Elektronenmikroskop, das eine Elektronenemissionsvorrichtung (10) nach einem der Ansprüche 1 bis 7, eine Säule, die elektronische Optikkomponenten umfasst, und Mittel (76) zum Beschleunigen der von der Elektronenemissionsvorrichtung emittierten Elektronen umfasst.

10. Elektronenmikroskop nach Anspruch 9, bei dem die Elektronenbeschleunigungsmittel (76) zum Erzeugen einer Beschleunigungsspannung zwischen mehreren kV und mehreren MV ausgelegt sind.

11. Verfahren zum Emittieren von Elektronen durch Feldeffekt, das die folgenden Schritte beinhaltet:
- Bereitstellen einer Elektronenemissionsvorrichtung nach einem der Ansprüche 1 bis 7;
- Emittieren einer elektromagnetischen Welle zur Außenseite des Gehäuses (12) durch die Elektromagnetische-Wellen-Quelle (22) der Elektronenemis sionsvorrichtung;
- Propagieren der zur Innenseite des Gehäuses (12) emittierten elektromagnetischen Welle bis in die Nähe der Spitze (14) durch das Leitsystem (24);
- Fokussieren der elektromagnetischen Welle im Innern des Gehäuses (12) auf die Spitze (14) durch das Fokussiersystem (26); und
- Ausrichten der auf die Spitze (14) fokussierten elektromagnetischen Welle, wobei der Ausrichtungsschritt von der Außenseite des Gehäuses (2) durch das Ausrichtsystem (28) realisiert wird.

12. Verwenden der Elektronenemissionsvorrichtung nach einem der Ansprüche 1 bis 7 oder des Elektronenemissionsverfahrens nach Anspruch 11 zum Emittieren von Elektronen auf kontrollierte Weise durch die Elektromagnetische-Wellen-Quelle.

## Claims

1. A device (10) for the field emission of electrons comprising:
- a vacuum chamber (12) comprising a needle (14) comprising an end (18) and forming a cold cathode, an extraction anode (16), components adapted to generate a potential difference between the needle (14) and the anode (16);
- an electromagnetic wave source (22) outside the chamber (12);
- a system (24) for routing the electromagnetic wave emitted by the electromagnetic wave source from the outside to the inside of the chamber until it is in the vicinity of the needle (14);
- a system (26) for focusing the electromagnetic wave arranged inside the chamber (12); and
- a system (28) for aligning the electromagnetic wave arranged outside the chamber and adapted to allow the electromagnetic wave focused by the focusing system to be aligned on the end of the needle,
the focusing system (26) comprising a flat mirror (50) and a parabolic or spherical mirror (52) disposed either side of the needle (14), each mirror (50, 52) being connected to the same electric potential as the needle (14), the routing system (24) being adapted to route the electromagnetic wave from the side of the needle (14) opposite the extraction anode (16) until it is in the vicinity of the end (18), such that an electromagnetic wave that is emitted by the source (22), aligned by the alignment system (28), routed by the routing system (24) from behind the needle (14), and focussed by the focusing system (26), is propagated until it is at the end (18) of the needle (14) at an angle included in a range of 45° to 135°, preferably substantially perpendicular to the axis of the needle (14).

2. The electrons emission device (10) as claimed in the preceding claim, wherein the routing system (24) comprises an inlet port (36) adapted to transmit the electromagnetic wave from the outside to the inside of the chamber (12) and a hollow tube (32) adapted to propagate the electromagnetic wave in the chamber until it is in the vicinity of the end of the needle (14), the tube being made of material having dielectric stiffness that is substantially included in a range of 10 to 40 kV/mm.

3. The electrons emission device as claimed in the preceding claim, wherein the inlet port (36) is made of ceramic transparent to the wavelengths of the electromagnetic wave emitted by the source (22).

4. The electrons emission device as claimed in any one of the preceding claims, wherein the alignment system (28) comprises at least two scanning mirrors (54, 56) and an optical system (58), for example telescopic or telecentric.

5. The electrons emission device as claimed in any one of the preceding claims, wherein the alignment system (28) is adapted to perform a scan of the focused electromagnetic wave of at least 0.5 mm in each of the three dimensions around the needle (14).

6. The electrons emission device as claimed in any one of the preceding claims, wherein the needle (14) is selected from the following list:
- a needle made of tungsten oriented along different crystallographic axes;
- a needle in the shape of a cone made of material comprising carbon;
- a needle made of gold.

7. The electrons emission device as claimed in any one of the preceding claims, wherein the electromagnetic wave source (22) is a laser and particularly a femtosecond laser.

8. A system comprising at least one electrons emission device as claimed in any one of claims 1 to 7, the system being selected from the following list:
- a transmission or scanning electron microscope;
- an ultrafast electron diffraction device;
- an electron lithography system.

9. An electron microscope comprising an electrons emission device (10) as claimed in any one of claims 1 to 7, a column comprising electron optic components and means (76) for accelerating electrons emitted by the electrons emission device.

10. The electron microscope as claimed in claim 9, wherein the means (76) for accelerating electrons are adapted to generate an accelerating voltage included in a range of a few kV to a few MV.

11. A method for the field emission of electrons comprising the following steps:
- supplying an electrons emission device as claimed in any one of claims 1 to 7;
- emitting an electromagnetic wave outside the chamber (12) by the electromagnetic wave source (22) of the electrons emission device;
- propagating, by the routing system (24), the emitted electromagnetic wave towards the inside of the chamber (12) until it is in the vicinity of the needle (14);
- focusing, by the focusing system (26), the electromagnetic wave inside the chamber (12) on the needle (14); and
- aligning, by the alignment system (28), the electromagnetic wave focused on the needle (14), the alignment step being performed from outside the chamber (2).

12. The use of the electrons emission device as claimed in any one of claims 1 to 7 or of the electrons emission method as claimed in claim 11 for the controlled emission of electrons by the electromagnetic wave source.
